# EUROPEAN PATENT APPLICATION

(11) **EP 3 761 343 A1**
(43) Date of publication of application: **06.01.2021**
(21) Application number: 19184224.4
(22) Date of filing: 03.07.2019
(51) Int. Cl.: H01L 21/02

(54) **METHOD FOR MANUFACTURING A SILICON ON NITRIDE SUBSTRATE**

(71) Applicant: IMEC vzw, 3001 Leuven (BE)
(72) Inventor: LIANG, Hu, 3001 Leuven (BE); PENG, Lan, 3001 Leuven (BE)
(74) Representative: AWA Sweden AB

(57) **Abstract**

According to an aspect of the present inventive concept there is provided a method for manufacturing a silicon on nitride, SON, substrate (1). The method comprises the steps of providing a semiconductor layer (2) of a first crystal orientation, forming, on the semiconductor layer, an interface layer (3) comprising a monocrystalline III-nitride layer forming a nucleation layer for a subsequent epitaxy process, and bonding a silicon substrate (4) of a second crystal orientation with the interface layer.

## Description

### Technical field

The present inventive concept relates to the field of semiconductor processing, and in particular to manufacturing of a silicon on nitride substrate.

### Background

III-nitride high-electron-mobility transistors, HEMTs, have attracted great interest in high power and high frequency electronics applications because of their superior intrinsic material characteristics like wider energy bandgap and higher breakdown. These advantages in III-nitride HEMTs enable faster switching times, reduced switching losses, higher blocking voltage, and higher frequency operation compared to silicon, Si, based counterparts and can be widely used in the high power electronic applications and radio frequency, RF, applications. The technology of III-nitride material growth on Si provides an opportunity to fabricate devices cost effectively in a lab. It also provides for a system level design that monolithically integrates III-nitride devices with Si based complementary metal-oxide-semiconductor, CMOS, circuits.

However, there are several issues that make it a challenge for the III-nitride devices to be monolithically integrated with CMOS circuits. In particular, there may be a large mismatch in coefficient of thermal expansion, CTE, between the III-nitride material and Si, making it a challenge to control the residual stresses and the wafer bow across the whole wafer. The effect of residual stresses is a particular challenge when scaling the process to larger substrates.

A typical method for scaling the process from a 200 mm to a 300 mm wafer may for example be to use selective area epitaxy, SAE, for the III-nitride device growth. This is however a complicated process that involves the processing of mask layers for the selective growth and layers for protecting the surface of the Si substrate from being damaged by melt back.

### Summary

An object of the present invention is to at least partly alleviate the above-discussed drawbacks of the prior art. This and other objects are achieved by a method for manufacturing a silicon on nitride, SON, substrate and a SON substrate according to the present inventive concept.

According to an aspect of the present inventive concept there is provided a method for manufacturing a SON substrate, the method comprising the steps of:
a) providing a semiconductor layer of a first crystal orientation,
b) forming, on the semiconductor layer, an interface layer comprising a monocrystalline III-nitride layer forming a nucleation layer for a subsequent epitaxy process, and
c) bonding a silicon substrate of a second crystal orientation with the interface layer.

By following the steps presented above, a SON substrate is provided, which can be used as a common platform to integrate a wide variety of III-nitride devices with for example complementary metal-oxide-semiconductor, CMOS, technologies. Using a monocrystalline III-nitride layer to form a nucleation layer is advantageous since such a layer may be relative thin, such as about 200 nm. This allows for stresses into the Si layers to be kept to a minimum, thereby reducing the flexing that otherwise may be induced in the surrounding layers. Furthermore, a monocrystalline nucleation layer gives the possibility of growing crystal layers with a high crystal quality, for example comprising a threading dislocation density below 3x10⁹ cm⁻². The SON substrate according to the present inventive concept may also be monolithically integrated with III-nitride based devices. Using a SON substrate, which is suitable for scaled production, as a building block for creating III-nitride HEMTs with the before mentioned fundamental advantages, allows these advantages to be realized within the field of high power electronics and radio frequency, RF, applications.

The semiconductor layer may have a similar CTE as the interface layer to avoid delamination and stresses in the boundary in-between the interface layer and the semiconductor layer. The semiconductor layer may comprise any semiconducting material, such as III-V materials, Si, doped Si etc., suitable support a monocrystalline III-nitride layer.

The monocrystalline III-nitride layer may serve the purpose of protecting the semiconductor layer during a subsequent epitaxy process and ensure that a high quality nucleation and buffer layer is present for the subsequent epitaxy process. Examples of monocrystalline III-nitride layers include III-nitride materials such as AIN, aluminium nitride, GaN, gallium nitride, InN, indium nitride, etc.

The silicon substrate may be employed to prepare the SON substrate for integration with other devices and/or for further fabrication steps. Depending on the requirements determined by the subsequent processing, the type of silicon chosen for the silicon substrate may be for example un-doped silicon, p-doped silicon or n-doped silicon.

The interface layer may be formed by means of several different techniques, such as e.g. metalorganic chemical vapour deposition, MOCVD, physical vapour deposition, PVD, or Molecular-beam epitaxy, MBE.

The first crystal orientation and the second crystal orientation may in some examples be the same, and in other examples different. Furthermore, the crystal orientation may be chosen to minimize mismatching CTE's and / or to prepare the SON substrate as a building block for specific applications. Since the first crystal orientation and the second crystal orientation may be chosen independently of each other, a high degree of flexibility may be achieved regarding the usage purposes of the SON substrate.

The silicon substrate may be bonded with the interface layer by means of standard wafer bonding techniques, such as fusion bonding or surface activated bonding.

According to an embodiment, the method may further comprise the steps of:
d) removing a portion of the silicon substrate to expose the underlying interface layer, and
e) forming, by the epitaxy process, an epitaxial layer on the exposed interface layer, using the monocrystalline III-nitride layer as a nucleation layer.

Put differently, the silicon substrate may be patterned to define the regions in which the epitaxial layer is to be provided. The patterning may for example include removal of portions of the silicon substrate by means of dry etching or wet etching. It will be appreciated that the epitaxial layer may be provided to completely or at least partly fill the removed portion. In one example, the epitaxy process is selected such that an overgrowth is provided, followed by an etch-back or planarization process.

Forming of the epitaxial layer may be done directly on the exposed nucleation layer, which also may serve as a protection against melt back during the epitaxy process. The epitaxial layer may be formed by selective area epitaxy.

The resulting structure is an SON substrate comprising one or several regions of an epitaxial material, and one or several regions of silicon. The epitaxial region(s) may be used for the formation of for example HEMTs, whereas the silicon region(s) may serve as a basis for the CMOS processing. Thus, an integrated device is enables, comprising both silicon CMOS devices and HEMT devices formed in for example a III-nitride material such as GaN.

According to an embodiment, the monocrystalline III-nitride layer may comprise AIN, whereas the epitaxial layer may be formed of a III-nitride material, such as for example GaN.

A monocrystalline III-nitride layer comprising AIN may act as a nucleation layer for subsequent epitaxy growth of III-nitride materials.

Even though GaN is mentioned as an example, the inventive concept should not be construed as limited to GaN. AIGaN, InGaN or InAIGaN may also be grown on top of the nucleation layer.

According to an embodiment, the monocrystalline III-nitride layer further comprises GaN.

The addition of GaN to the monocrystalline III-nitride layer may further facilitate growth of for example high quality GaN crystals.

According to an embodiment, the interface layer may further comprise a bonding layer formed on the monocrystalline III-nitride layer. The bonding layer may be provided to improve the bonding between the second Si layer and the monocrystalline III-nitride layer and thereby achieve a robust SON substrate which can easily be used in further processes, e.g. high temperature annealing, with a reduced risk of delamination between the different layers.

The bonding layer may for example be formed by epitaxy growth or by deposition on the monocrystalline III-nitride layer.

According to an embodiment, the bonding layer may be formed of Si₃N₄, which may increase the thermal stability of the layer and further improve its electrical insulating and passivating properties. These properties may be particularly desirable if the SON substrate is to be used for HEMTs. The bonding layer may for example be formed by means of in-situ epitaxy growth, or by means of ex-situ deposition.

According to an embodiment, the method may further comprise the forming of a thermal oxide on the silicon substrate prior to the bonding. The thermal oxide may serve as an insulating, passivating and/or protecting layer, and may furthermore serve to enhance bonding of layers to the second Si layer.

According to an embodiment, the semiconductor layer may have a crystal orientation of [111] and the silicon substrate a crystal orientation of [100].

The crystalline orientations may be chosen depending on the type of monocrystalline III-nitride material that is used. In some cases, it may be preferable to grow the monocrystalline III-nitride material, such as for example Si₃N₄ and AIN or Ga/AIN on a semiconductor layer with a crystal orientation of [111] in order to reduce the mismatch of coefficient of thermal expansion between the two layers. Furthermore, using a silicon substrate with a crystal orientation of [100] is advantageous due to its compatibility with current CMOS technology.

According to an embodiment, the semiconductor layer and the silicon substrate may be provided in the form of 200 or 300 mm wafers. One of the advantages with the present inventive concept is that it can be carried out on both 200 mm and 300 mm wafers, since the problems with residual stresses are alleviated.

According to another aspect of the present inventive concept, a SON substrate is provided. This aspect may generally present the same or corresponding advantages as the former aspect. The SON substrate comprises:
a semiconductor layer of a first crystal orientation,
a silicon substrate of a second crystal orientation, and
an interface layer, the interface layer comprising a monocrystalline III-nitride layer, wherein:
   the interface layer is formed on the semiconductor layer,
   the silicon substrate bonded to the interface layer, and
   the monocrystalline III-nitride layer forms a nucleation layer for a subsequent epitaxy process.

Other objectives, features and advantages of the present inventive concept will appear from the following detailed disclosure, from the attached claims as well as from the drawings. A feature described in relation to one of the aspect may also be incorporated in the other aspect, and the advantage of the feature is applicable to all aspects in which it is incorporated.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figs. 1a-c are cross-sectional side views illustrating a workflow overview of a method for manufacturing a SON substrate according to an embodiment.
Figs. 2a-c are cross-sectional side views illustrating a workflow overview of subsequent manufacturing steps carried out on the SON substrate.
Fig. 3 is a cross-sectional side view of a SON substrate, where the monocrystalline III-nitride layer of the SON substrate comprises two materials, AIN and GaN.
Fig. 4 is a cross-sectional side view of a SON substrate, where a bonding layer is formed on the monocrystalline III-nitride layer.
Fig. 5 is a cross-sectional side view of a SON substrate, where a thermal oxide has been formed on the silicon substrate.

### Detailed description

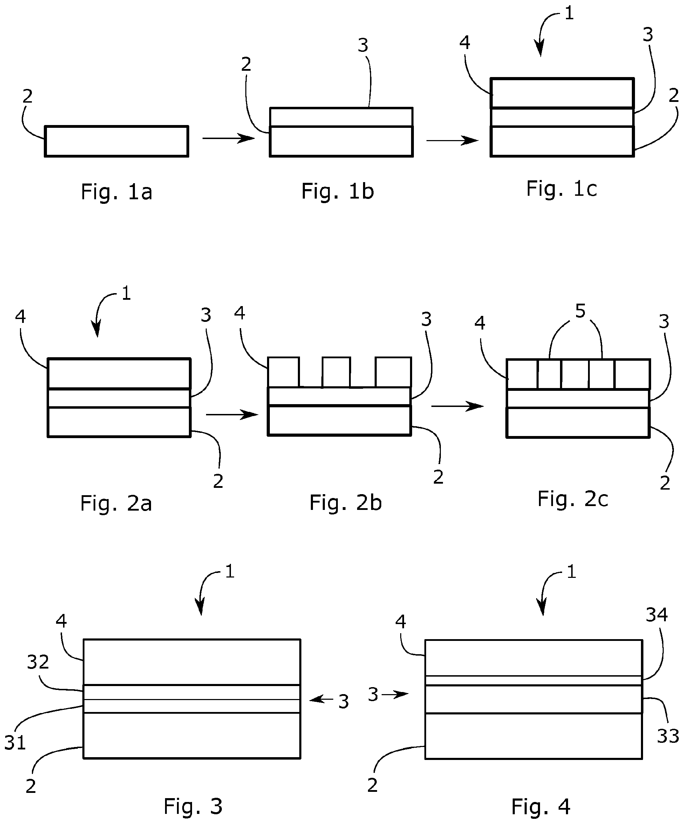

Referring initially to Figs. 1a-c, a method for manufacturing a SON substrate 1 is illustrated. Fig. 1a illustrates the first step of providing a semiconductor layer 2 of a first crystal orientation. The semiconductor layer 2 may for example be formed of silicon, and preferably crystalline silicon having a crystal orientation of [111] (Si(111)). In the present embodiment, the semiconductor layer 2 may be provided in the form of a wafer, such as a 200 mm wafer or a 300 mm wafer, serving as a substrate onto which the resulting SON substrate 1 is built by means of the manufacturing process according to the present invention. Alternatively, the semiconductor layer 2 may be provided as a layer or region on a wafer. Such a wafer may in some cases comprise a plurality of regions or areas provided with the semiconductor layer 2.

In Fig. 1b, an interface layer 3 has been formed on the semiconductor layer 2. The interface layer 3 may comprise a monocrystalline III-nitride layer forming a nucleation layer for a subsequent epitaxy process. The monocrystalline III-nitride layer may comprise one or more III-nitride materials, such as AIN, GaN, BN, etc., which may be provided on the semiconductor layer 2 by metalorganic chemical vapour deposition, MOCVD, physical vapour deposition, PVD, or Molecular-beam epitaxy, MBE. The interface layer 3 may be chosen depending on the semiconducting layer 2. If for example the semiconducting layer 2 is formed of silicon and the interface layer 3 comprises AIN, it may be preferable to choose the semiconducting layer 2 to be silicon with a crystal orientation of [111] to minimize effects of mismatching CTEs.

Fig. 1c illustrates the resulting SON substrate 1, where a silicon substrate 4 of a second crystal orientation has been bonded with the interface layer 3. The silicon substrate 4 may be formed of un-doped silicon, p-doped silicon or n-doped silicon. The silicon substrate 4 may in some embodiments be formed of silicon with a crystal orientation of [100].

By bonding the silicon substrate 4 to the interface layer 3, the SON substrate 1 shown in figure 1c is provided. The bonding may be carried out by means of a large variety of bonding processes known in the art, such as a standard fusion bonding, anodic bonding, reactive bonding, adhesive bonding, etc.

The resulting SON substrate 1 may be subjected to additional process steps. In some cases, it may be preferable to anneal the SON substrate 1 to remove stresses in the SON substrate 1, and to heal damages and defects of the SON substrate 1 by recrystallization.

Figs. 2a-c illustrate subsequent manufacturing steps that may be carried out on a SON substrate 1 according to an embodiment. Fig. 2a illustrates a SON substrate 1 that may be similarly configured as the SON substrate 1 shown in figure 1c, comprising a semiconductor layer 2, on which an interface layer 3 is formed. Further, a silicon substrate 4 is bonded to the interface layer 3.

Fig. 2b illustrates the SON substrate 1 after the silicon substrate 4 has been patterned by removing portions of the silicon substrate 4 to expose the underlying interface layer 3.

The silicon substrate 4 may be patterned by a lithography process, followed by a wet etch or a dry etch. The etch may be performed by means of an etch mask formed on the silicon substrate 4. The masking material may for example be silicon dioxide, silicon nitride, a negative photo resist or a positive photo resist. The masking material may be formed on the SON substrate 1 by means of a heat treatment process, MOCVD, spin coating or dip coating, and the resulting mask layer may be patterned by a lithography process, dry etching or wet etching. If the silicon substrate 4 is silicon with a crystalline orientation of [100], it may be advantageous to use KOH as the etchant, as KOH is widely used and the etching characteristics between KOH and silicon [100] is well known. Other etchants such as HF or H₂SO₄ may however also be used. After the etching of the silicon substrate 4, the resulting substrate 1 may be passivated to ensure no further etching takes place. The etch mask may be removed by an oxide strip, a wet etch, etc. Alternatively, the etch mask is kept, particularly in case the masking material has the desired properties regarding for example passivation, surface protection and/or mechanical stability.

The silicon substrate 4 may be patterned by forming trenches, grooves or other structures in the silicon substrate 4.

Fig. 2c illustrates the SON substrate 1 after the formation of an epitaxial layer 5 on the exposed interface layer 3 portions. The epitaxial layer 5 may for example be formed by means of an epitaxy process, using the monocrystalline III-nitride layer 3 as a nucleation layer. The epitaxy process may be for example a SAE process, heteroepitaxy process or homoepitaxy process. If the interface layer comprises AIN, a heteroepitaxy process may be carried out to form GaN or AlGalnP as the epitaxial layer 5 on top on of the interface layer 3. If the interface layer 3 comprises GaN, a homoepitaxy process may be carried out to form GaN as the epitaxial layer 5 on top on of the interface layer 3. By using the monocrystalline III-nitride layer 3 as a nucleation layer a high quality epitaxial layer 5 may be formed during the epitaxy process, giving a good starting point for integrating the SON substrate 1 with other semiconductor devices, further giving a product, which may be monolithically integrated with CMOS devices.

In the present figure, the epitaxial layer 5 is illustrated as a layer that completely fills the trenches defined by the patterned silicon substrate 4. This particular example may be formed by growing GaN in the trenches, using AIN as a nucleation layer, followed by a planarization by means of for example CMP.

Fig. 3 illustrates a SON substrate 1 according to an embodiment, which may be similarly configured as the embodiments discussed above in connection with figures 1 and 2. In the present example, the interface layer 3 may comprise two materials, AIN 31 and GaN 32. The AIN 31 and GaN 32 may be deposited via MOCVD or similar techniques. By forming a monocrystalline GaN 32 material on top of the AIN 31 material, a nucleation layer is provided which may facilitate the forming of high quality GaN crystals, for example having a threading dislocation density below 3*10⁹ cm⁻³, during epitaxy growth. It is however appreciated that the SON substrate 1 may comprise other combinations of III-nitride materials as well, such as e.g. BN and AIN, GaN and BN or InN and BN. Furthermore, the monocrystalline III-nitride layer 3 may also comprise more than two III-nitride materials, such as for example three or four III-nitride materials.

Fig. 4 illustrates a SON substrate which may be similar to the substrates of the previous figures, wherein the interface layer 3 comprises a bonding layer 34 formed on the monocrystalline III-nitride layer 33. The bonding layer may be deposited by for example in-situ epitaxy growth or by ex-situ deposition. The bonding layer 34 may provide a suitable bonding interface between the silicon substrate 4 and the interface layer 3. The bonding layer 34 may for example comprise silicon dioxide, SiO2 and/or silicon nitride, Si₃N₄.

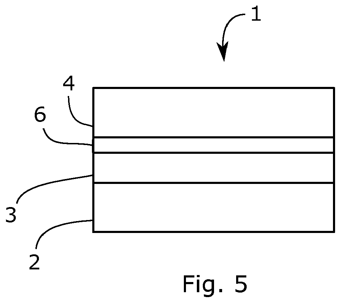

Fig. 5 illustrates a SON substrate, which may be similarly configured as the previous embodiments. As indicated in the present figure, a thermal oxide 6 may be formed on the silicon substrate 4. The thermal oxide 6 may act as a protecting layer or act to enhance bonding to the silicon substrate 4. The thermal oxide 6 may also act as an etch mask when patterning the silicon substrate 4. The thermal oxide 6 may be formed on the silicon substrate 4 or on the interface layer 3 prior to bonding.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for manufacturing a silicon on nitride, SON, substrate (1), the method comprising the steps of:
a) providing a semiconductor layer (2) of a first crystal orientation,
b) forming, on the semiconductor layer, an interface layer (3) comprising a monocrystalline III-nitride layer forming a nucleation layer for a subsequent epitaxy process, and
c) bonding a silicon substrate (4) of a second crystal orientation with the interface layer.

2. A method according to claim 1, further comprising the steps of:
d) removing a portion of the silicon substrate to expose the underlying interface layer, and
e) forming, by the epitaxy process, an epitaxial layer on the exposed interface layer, using the monocrystalline III-nitride layer as a nucleation layer.

3. A method according to claim 2, wherein the monocrystalline III-nitride layer comprises AIN and the epitaxial layer is formed of a III-nitride material for example GaN.

4. A method according to claim 3, where the monocrystalline III-nitride layer further comprises GaN.

5. A method according to any of the preceding claims, where the interface layer further comprises a bonding layer formed on the monocrystalline III-nitride layer.

6. A method according to claim 4, where the bonding layer is formed of Si3N4.

7. A method according to any of the preceding claims, wherein the forming of the monocrystalline III-nitride layer and/or the epitaxy process is a metal organic chemical vapour deposition, MOCVD, process.

8. A method according to any of the preceding claims, further comprising forming a thermal oxide on the silicon substrate prior to the bonding.

9. A method according to any of the preceding claims, where the semiconductor layer has a crystal orientation of [111] and the silicon substrate has a crystal orientation of [100].

10. A method according to any of the preceding claims, where the semiconductor layer and the silicon second substrate is provided in the form of 200 or 300 mm wafers.

11. A silicon on nitride, SON, substrate (1) comprising:
a semiconductor layer (2) of a first crystal orientation,
a silicon substrate (4) of a second crystal orientation, and
an interface layer (3), the interface layer comprising a monocrystalline III-nitride layer, wherein:
the interface layer is formed on the semiconductor layer,
the silicon substrate bonded to the interface layer, and
the monocrystalline III-nitride layer forms a nucleation layer for a subsequent epitaxy process.

12. A SON substrate according to claim 11, wherein the interface layer further comprises a bonding layer provided between the monocrystalline III-nitride layer and the silicon substrate.

13. A SON substrate according to claim 12, where the bonding layer is formed of Si3N4.

14. A SON substrate according to any of claims 11-13, where the monocrystalline III-nitride layer is formed of AIN and/or GaN.

15. A SON substrate according to any of claims 11-14, where the semiconductor layer has a crystal orientation of [111] and the silicon substrate has a crystal orientation of [100].
